# EUROPÄISCHE PATENTSCHRIFT

(11) **EP 1 224 674 B1**
(45) Veröffentlichungstag und Bekanntmachung des Hinweises auf die Patenterteilung: **19.10.2005**
(21) Anmeldenummer: 00960913.2
(22) Anmeldetag: 08.09.2000
(51) Int. Cl.: H01G 4/38

(54) **VERFAHREN ZUR HERSTELLUNG EINES KONDENSATORBAUELEMENTS**
PROCESS OF MANUFACTURING A CAPACITOR COMPONENT
PROCEDE DE FABRICATION D'UN COMPOSANT CONDENSATEUR

(30) Priorität: 10.09.1999 DE 19943251
(43) Veröffentlichungstag der Anmeldung: 24.07.2002
(73) Patentinhaber: Marconi Communications GmbH, 71522 Backnang (DE)
(72) Erfinder: PURSCHE, Udo, D-01129 Dresden (DE)
(74) Vertreter: Grosse, Rainer
(86) Internationale Anmeldenummer: PCT/IB2000/001370
(87) Internationale Veröffentlichungsnummer: WO 2001/020623

(56) Entgegenhaltungen:
- PATENT ABSTRACTS OF JAPAN vol. 1997, no. 02, 28. Februar 1997 (1997-02-28) & JP 08 274508 A (MURATA MFG CO LTD), 18. Oktober 1996 (1996-10-18)
- PATENT ABSTRACTS OF JAPAN vol. 014, no. 178 (E-0915), 10. April 1990 (1990-04-10) & JP 02 032516 A (SUMITOMO ELECTRIC IND LTD), 2. Februar 1990 (1990-02-02) & JP 02 032516 A (SUMITOMO ELECTRIC IND CO LTD) 2. Februar 1990 (1990-02-02)
- PATENT ABSTRACTS OF JAPAN vol. 013, no. 370 (P-920), 17. August 1989 (1989-08-17) & JP 01 126730 A (AGENCY OF IND SCIENCE & TECHNOL), 18. Mai 1989 (1989-05-18)
- PATENT ABSTRACTS OF JAPAN vol. 1999, no. 11, 30. September 1999 (1999-09-30) & JP 11 154621 A (TDK CORP), 8. Juni 1999 (1999-06-08)

## Beschreibung

### Stand der Technik

Die Erfindung betrifft ein Verfahren zur Herstellung eines Kondensatorbauelements.

Ein Kondensatorbauelement ist beispielsweise aus der US 5 034 850 bekannt und umfasst eine Keramikplatte, auf die eine erste Elektrodenschicht aufgebracht ist. Auf die erste Elektrodenschicht ist eine dünne dielektrische Schicht gefolgt von einer zweiten Elektrodenschicht aufgebracht. Die Anschlüsse der Elektrodenschicht sind seitlich aus dem Bauelement herausgeführt und durch auf die Stirnseiten des Kondensatorbauelementes aufgebrachte Leiter auf die Unterseite der Keramikplatte geführt. Derartige Kondensatorbauelemente werden als diskrete kapazitive Bauelemente beispielsweise auf Leiterplatten bestückt und mit den dort vorhandenen Leiterbahnen verlötet. Nachteilig ist nicht nur die aufwendige Ausgestaltung der Anschlüsse, welche die Herstellung derartiger Kondensatorbauelemente relativ stark verteuert, sondern ferner, dass die Kapazitäten von zwei gleichartig aufgebauten Kondensatorbauelementen, die jeweils einen einzelnen Kondensator umfassen, stark voneinander abweichen können.

Gründe hierfür sind in den Toleranzen bei der Herstellung der Bauelemente zu suchen. So können die aufgebrachten Elektrodenschichten in ihrer Dicke und Flächenausdehnung von Mal zu Mal schwanken. Weiterhin führen Dickenschwankungen der verwandten dielektrischen Schicht und ein unterschiedlich großer Versatz der oberen und unteren Kondensatorelektroden bei der Herstellung zu verschiedenen Kapazitätswerten der hergestellten Bauelemente. Aus diesen Gründen können die bekannten Kondensatorbauelemente nicht in allen elektronischen Schaltungen verwandt werden. Insbesondere für elektronische Brückenschaltungen, bei denen die Verwendung von Kondensatoren mit möglichst genau übereinstimmenden Kapazitätswerten erforderlich ist, sind die bekannten Kondensatorbauelemente nicht geeignet.

Aus der JP 08274508 geht ein Kondensatorelement für ein dielektrisches Filter hervor, wobei eine Vielzahl derartiger Kondensatorelemente hergestellt und - zur Vereinfachung der bisher manuell vorgenommenen Kapazitätskontrolle - mittels einer geraden Nut versehen wird. Durch die Nut werden die Platten zweier Kondensatoren auf die gewünschte Größe und damit auf den gewünschten Kapazitätswert gebracht. Die sich auf der Oberseite eines Substrats befindenden Platten wirken mit Platten zusammen, die sich auf der Unterseite des Substrats befinden. Die Nut wird auf der Oberseite des Substrats eingebracht. Auf welche Art und Weise die Platten erstellt wurden, geht aus der genannten Literaturstelle nicht hervor.

Die JP 11154621 befasst sich mit an einem Substrat ausgebildeten Kondensatoren, deren Zuleitungen auf unterschiedlichen Substratseiten liegen und diagonal versetzt hinsichtlich jedes Kondensators angeordnet sind, um den Kapazitätswert nicht zu verfälschen. Auf welche Art und Weise die Kapazitäten hergestellt wurden, wird nicht offenbart.

### Vorteile der Erfindung

Mit dem erfindungsgemäßen Verfahren zur Herstellung eines Kondensatorbauelements nach dem Anspruch 1 werden die im Stand der Technik bekannten Nachteile vermieden. Durch das erfindungsgemäße Verfahren weist das Kondensatorbauelement wenigstens zwei gleichartig aufgebaute Kondensatoren auf, deren dielektrische Schicht durch die gleiche dielektrische Trägerplatte gebildet wird. Da die Elektroden auf der Oberseite und der Unterseite der dielektrischen Trägerplatte im gleichen Herstellungsverfahren auf dem gleichen Substrat erzeugt werden, wird erreicht, dass ein Versatz zwischen oberer und unterer Elektrodenschicht oder eine aus Mengenschwankungen bei der Materialauftragung resultierende Dickenabweichung der Elektrodenschichten die Größe der Kapazitäten der beiden Kondensatoren immer im gleichen Maß beeinflusst. Die relativen Kapazitätsabweichungen bleiben damit immer sehr klein. Ein vereinfachter Aufbau des Kondensatorbauelements ergibt sich aus einer auf der Oberseite und der Unterseite mit Elektrodenschichten versehenen dielektrischen Schicht, welche zugleich als Trägerplatte dient. Hierdurch entfällt die Notwendigkeit, einen separaten Träger zur mechanischen Stabilisierung für die Kondensatorstrukturen vorzusehen. Dabei wird so verfahren, dass die erste und dritte Elektrodenschicht auf der Oberseite der Trägerplatte in einem gemeinsamen Verfahrensschritt und die zweite und vierte Elektrodenschicht auf der Unterseite ebenfalls in einem gemeinsamen Verfahrensschritt unter den gleichen Prozessbedingungen auf die dielektrische Trägerplatte aufgebracht werden. Hierdurch lassen sich vorteilhaft auf einer Seite der Trägerplatte Elektrodenschichten mit geometrischen Abmessungen erzeugen, die nur äußerst geringfügig voneinander abweichen. Somit weisen die gebildeten Kondensatoren des Kondensatorbauelementes alle die gleiche Kapazität auf.

Weiterentwicklungen der Erfindung und vorteilhafte Ausführungen werden durch die in den Unteransprüchen angegebenen Merkmale ermöglicht.

Mit Vorteil wird als dielektrische Trägerplatte eine Keramikplatte verwendet. Die Herstellung derartiger Platten mit hoher Präzision ist leicht und preiswert realisierbar.

Vorteilhaft werden die Elektrodenschichten in Dickschicht- oder Dünnschichttechnik auf die dielektrische Trägerplatte aufgebracht.

Vorteilhaft kann das Kondensatorbauelement als diskretes Bauelement auf einen Baugruppenträger bestückt werden und mit dort vorhandenen Leiterbahnen beispielsweise im Reflowlötverfahren elektrisch und mechanisch kontaktiert werden. Die auf der Oberseite des Kondensatorbauelementes vorhandenen Elektrodenschichten werden über Bonddrähte mit weiteren Leiterbahnen des Baugruppenträgers kontaktiert. Die Bestückung des Kondensatorbauelementes ist somit relativ einfach und preiswert und mit gut beherrschten Techniken durchführbar.

### Zeichnung

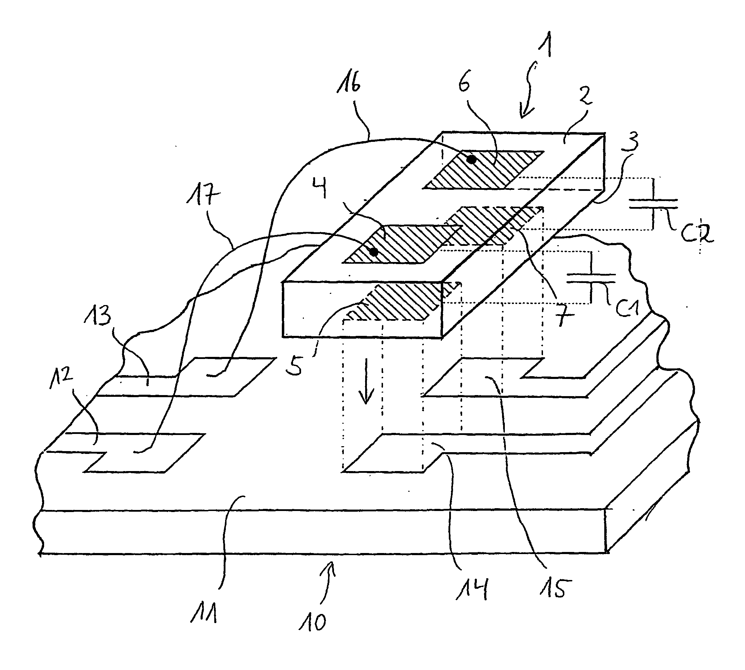

Ein Ausführungsbeispiel der Erfindung wird in der Zeichnungen dargestellt und in der nachfolgenden Beschreibung erläutert. Die einzige Figur zeigt schematisch einen Baugruppenträger mit dem erfindungsgemäßen Kondensatorbauelement.

### Beschreibung des Ausführungsbeispiels

Wie in der einzigen Figur gezeigt ist, umfaßt das erfindungsgemäße Kondensatorbauelement eine im wesentlichen quaderförmige dielektrische Trägerplatte 1, beispielsweise eine Keramikplatte mit hoher Dielektrizitätskonstante. Auf die Oberseite 2 der dielektrischen Trägerplatte 1 ist eine erste Elektrodenschicht 4 und eine dritte Elektrodenschicht 6 aufgebracht. Weiterhin sind auf die Unterseite 3 der dielektrischen Trägerplatte 1 eine zweite Elektrodenschicht 5 und eine vierte Elektrodenschicht 6 aufgebracht. Die Elektrodenschichten 4-7 weisen alle die gleichen geometrischen Abmessungen auf, also die gleich Flächenausdehnung und Schichtdicke, und sind vorzugsweise rechteckförmig ausgebildet. Durch die erste Elektrodenschicht 4 auf der Oberseite 2 der Trägerplatte und die ihr auf der Unterseite 3 der Trägerplatte 1 gegenüberliegende zweite Elektrodenschicht 5 wird, wie in der Figur durch das entsprechende Kondensatorsymbol angedeutet ist, ein erster Kondensator C1 gebildet. Die dritte Elektrodenschicht 6 bildet mit der ihr auf der Unterseite 3 gegenüberliegenden vierten Elektrodenschicht 7 einen zweiten Kondensator C2 aus. Beide Kondensatoren C1,C2 des Kondensatorbauelements weisen bis auf äußerst geringe Abweichungen, die im Rahmen der Meßgenauigkeit kaum nachweisbar sind, die gleiche Kapazität auf.

Die Elektrodenschichten können in Dickschichttechnik oder Dünnschichttechnik auf das dielektrische Trägersubstrat 1 aufgebracht werden. Möglich sind beispielsweise Dünnschichttechnologien, wie beispielsweise fotolithografische Prozesse, Bedampfen oder Sputtern zur Abscheidung von Metallisierungen auf der Trägerplatte, welche die Elektrodenschichten bilden. Eine andere Möglichkeit der Erzeugung der Elektrodenschichten besteht in Dickschichttechnologien wie beispielsweise dem Siebdruckverfahren.

Unabhängig von der verwandten Herstellungstechnik wird so verfahren, daß die Elektrodenschichten auf der Oberseite und die Elektrodenschichten auf der Unterseite jeweils in einem gemeinsamen Verfahrensschritt unter den gleichen Prozeßbedingungen und Umgebungseinflüssen hergestellt werden. So werden die Elektrodenschichten 4,6 beispielsweise im gleichen Fotolithographie-Prozeß, im gleichen Bedampfungsschritt oder dem gleichen Siebdruckschritt erzeugt. Ebenso die Elektrodenschichten 5,7 auf der Unterseite. Auf diese Weise kann sichergestellt werden, daß Schwankungen und Toleranzen bei der Materialabscheidung, beim Ätzen, Bedampfen oder Siebdrucken immer gleichartig bei allen Elektrodenschichten auftreten, die auf der gleichen Seite des Trägersubstrats erzeugt wurden. Auch Deckungsfehler zwischen den Elektrodenschichten 4,6 der Oberseite 2 und Elektrodenschichten 5,7 der Unterseite treten bei beiden Kondensatoren C1, C2 immer gleichartig in Erscheinung. Eine größere Abweichung der Kapazitätswerte der beiden gebildeten Kondensatoren kann somit vermieden werden.

Einsprechendes gilt natürlich auch für ein Kondensatorbauelement, welches außer den beiden in diesem Ausführungsbeispiel gezeigten Kondensatoren noch weitere Kondensatoren mit weiteren Elektrodenschichten aufweist, die alle auf dem gleichen dielektrischen Trägersubstrat in der gleichen Weise erzeugt sind.

Vorzugsweise wird das Kondensatorbauelement in der Figur in Pfeilrichtung auf die Bestückungsseite 11 eines Baugruppenträgers 10, beispielsweise einer Leiterplatte aufgebracht. Auf der Bestückungsseite 11 befinden sich weitere nicht dargestellte elektrische und elektronische Schaltungsteile. Leiterbahnen 12-15 dienen zum Anschluß des Kondensatorbauelementes an die elekronischen Schaltungsteile. Die zur Kontaktierung vorgesehenen Enden der Leiterbahnen 14-15 werden beispielsweise mit Lotpaste bedruckt. Das Kondensatorbauelement wird anschließend in Richtung des in der Figur dargestellten Pfeils auf den Baugruppenträger 10 aufgesetzt, so daß die zweite und vierte Elektrodenschicht 5 und 7 auf den Enden der Leiterbahnen 14 und 15 aufliegt. Dies kann vorzugsweise auch in SMD-Technik (Surface mounted device) geschehen. Anschließend werden die Elektrodenschichten 5,7 in einer Reflow-Lötstation mit den Leiterbahnen 14,15 verlötet. Zuletzt werden dann im Anschluß an das Reflow-Lötverfahren die erste und dritte Elektrodenschicht 4,6 über jeweils einen Bonddraht 16,17 mit zwei weiteren Leiterbahnen 12,13 des Baugruppenträgers 10 elektrisch verbunden.

Durch die Bestückung des Kondensatorbauelementes auf dem Baugruppenträger 10 werden auf dem Baugruppenträger in sehr einfacher Weise zwei oder mehr als zwei Kondensatoren mit gleichen Kapazitätswerten bereit gestellt, die beispielsweise über die Leiterbahnen 12-15 des Baugruppenträgers mit einer Mikrowellen-Brückenschaltung verbunden werden können. Relativtoleranzen der Teilkondensatoren C1,C2 untereinander werden so weitgehend vermieden.

## Patentansprüche

1. Verfahren zur Herstellung eines Kondensatorbauelements zur Bestückung auf einem mit elektrischen Schaltungsteilen versehenen Baugruppenträger, umfassend einen Kondensator (C1), welcher aus einer ersten Elektrodenschicht, einer zweiten Elektrodenschicht und einem zwischen der ersten und zweiten Elektrodenschicht angeordneten dielektrischen Substrat besteht, das durch eine dielektrische Trägerplatte gebildet wird, wobei das Kondensatorbauelement wenigstens einen weiteren Kondensator (C2) mit einer dritten Elektrodenschicht und einer vierten Elektrodenschicht umfasst, wobei die erste und die dritte Elektrodenschicht auf der Oberseite und die zweite und vierte Elektrodenschicht auf der Unterseite der dielelektrischen Trägerplatte aufgebracht sind und die räumlichen Abmessungen der dritten Elektrodenschicht den Abmessungen der ersten Elektrodenschicht und die räumlichen Abmessungen der vierten Elektrodenschicht den Abmessungen der zweiten Elektrodenschicht entsprechen, mit folgenden Schritten:
- auf die Oberseite der das dielektrisches Substrat bildenden Trägerplatte wird in einem gemeinsamen Verfahrensschritt die erste und die dritte Elektrodenschicht gleichartig aufgebracht
- auf die Unterseite der Trägerplatte wird ebenfalls in einem gemeinsamen Verfahrensschritt die zweite und die vierte Elektrodenschicht gleichartig aufgebracht.

2. Verfahren nach Anspruch 1, **dadurch gekennzeichnet, dass** die Elektrodenschichten in Dickschicht- oder Dünnschichttechnik auf die dielektrische Trägerplatte aufgebracht werden.

3. Verfahren nach einem der vorhergehenden Ansprüche, **dadurch gekennzeichnet, dass** das dielektrische Trägersubstrat mit seiner Unterseite auf den Baugruppenträger aufgesetzt wird, wobei die auf der Unterseite des Trägersubstrats angeordnete zweite und vierte Elektrodenschicht auf jeweils eine Leiterbahn des Baugruppenträgers aufgebracht wird.

4. Verfahren nach Anspruch 3, **dadurch gekennzeichnet, dass** die zweite und die vierte Elektrodenschicht des Trägersubstrats auf die Leiterbahnen des Baugruppenträgers aufgelötet werden und dass die erste und zweite Elektrodenschicht über Bonddrähte mit jeweils einer weiteren Leiterbahn des Baugruppenträgers elektrisch kontaktiert werden.

## Claims

1. Method for manufacturing a capacitor component for placement on a component assembly carrier provided with electric circuit elements, comprising a capacitor (C1), which consists of a first electrode layer, a second electrode layer and a dielectric substrate which is disposed between the first and the second electrode layer and is constituted by a dielectric mounting plate, wherein the capacitor component comprises at least one further capacitor (C2), having a third electrode layer and a fourth electrode layer, wherein the first and the third electrode layer are applied on the top side of the dielectric mounting plate, and the second and the fourth electrode layer are applied on the underside of the dielectric mounting plate, and the spatial dimensions of the third electrode layer correspond to the dimensions of the first electrode layer and the spatial dimensions of the fourth electrode layer correspond to the dimensions of the second electrode layer, said method comprising the following steps:
- in a common method step, the first and the third electrode layer are applied in the same manner to the top side of the mounting plate constituting the dielectric substrate
- likewise, in a common method step, the second and the fourth electrode layer are applied in the same manner to the underside of the mounting plate.

2. The method according to Claim 1, **characterized in that** the electrode layers are applied to the dielectric mounting plate using thick-film or thin-film technology.

3. The method according to either of the preceding Claims, **characterized in that** the underside of the dielectric carrier substrate is placed on to the component assembly carrier, wherein the second and the fourth electrode layer disposed on the underside of the carrier substrate are applied to respectively one conductor track of the component assembly carrier.

4. The method according to Claim 3, **characterized in that** the second and the fourth electrode layer of the carrier substrate are soldered on to the conductor tracks of the component assembly carrier, and the first and the second electrode layer are electrically bonded, via bond wires, to respectively one further conductor track of the component assembly carrier.

## Revendications

1. Procédé de fabrication d'un composant condensateur à équiper sur un châssis équipé d'éléments de circuit électriques comportant un condensateur (C1) constitué d'une première couche d'électrodes, d'une deuxième couche d'électrodes et d'un substrat diélectrique placé entre la première et la deuxième couche d'électrodes, qui est formé par une plaque-support diélectrique, le composant condensateur comportant au moins un autre condensateur (C2) avec une troisième couche d'électrodes et une quatrième couche d'électrodes, la première et la troisième couche d'électrodes étant posées sur le dessus, et la deuxième et la quatrième couche d'électrodes sur le dessous de la plaque-support diélectrique, et les dimensions dans l'espace de la troisième couche d'électrodes correspondant aux dimensions de la première couche d'électrodes, et les dimensions dans l'espace de la quatrième couche d'électrodes correspondant aux dimensions de la deuxième couche d'électrodes, comportant les étapes suivantes :
la première et la troisième couche d'électrodes sont disposées de la même manière sur le dessus de la plaque-support formant le substrat diélectrique, lors d'une même étape du procédé
la deuxième et la quatrième couche d'électrodes sont disposées de la même manière sur le dessous de la plaque-support, également lors d'une même étape du procédé.

2. Procédé selon la revendication 1, **caractérisé en ce que** les couches d'électrodes sont disposées sur la plaque-support diélectrique selon une technique de couche épaisse ou de couche mince.

3. Procédé selon l'une des revendications précédentes, **caractérisé en ce que** le dessous du substrat support diélectrique est posé sur le châssis, la deuxième et la quatrième couche d'électrodes placées sur le dessous du substrat support étant posées sur respectivement une piste conductrice du châssis.

4. Procédé selon la revendication 3, **caractérisé en ce que** la deuxième et la quatrième couche d'électrodes du substrat support sont brasées sur les pistes conductrices du châssis et la première et la deuxième couche d'électrodes sont mises en contact électrique avec respectivement une ultérieure piste conductrice du châssis, par l'intermédiaire de fils de bonding.
